Europäisches Patentamt

European Patent Office

Office européen des brevets

(19)

(11) Numéro de publication : **0 462 000 B1**

(12) # FASCICULE DE BREVET EUROPEEN

(45) Date de publication du fascicule du brevet :
**15.12.93 Bulletin 93/50**

(51) Int. Cl.$^5$ : **G01R 33/26**

(21) Numéro de dépôt : **91401558.1**

(22) Date de dépôt : **12.06.91**

(54) **Magnétomètre à résonance et à pompage optique utilisant une pluralite de faisceaux multiplexes.**

(30) Priorité : **14.06.90 FR 9007413**

(43) Date de publication de la demande :
**18.12.91 Bulletin 91/51**

(45) Mention de la délivrance du brevet :
**15.12.93 Bulletin 93/50**

(84) Etats contractants désignés :
**BE DE GB IT NL SE**

(56) Documents cités :
**EP-A- 0 246 146**
**EP-A- 0 288 927**
**GB-A- 964 027**
**PATENT ABSTRACTS OF JAPAN vol. 6, no. 75**
**(P-114)(953) 12 Mai 1982 & JP-A-57 14 759**
**IEEE TRANSACTIONS ON NUCLEAR**
**SCIENCE, vol. NS-10, no. 1, Janvier 1963, NEW**
**YORK USA pages 165 - 171; R.E. SLOCUM,**
**F.N. REILLY: 'Low Field Helium Magnetometer**
**for Space Applications '**

(56) Documents cités :
**PATENT ABSTRACTS OF JAPAN vol. 12, no.**
**366 (P-765)(3213) 30 Septembre 1988 & JP-**
**A-63 117280**
**Doc. D2: "Optoélectronique" G. Broussaud**
**1974, Masson et Cie, P. 185-195: Chap. 6, 1-4**

(73) Titulaire : **COMMISSARIAT A L'ENERGIE**
**ATOMIQUE**
**31-33, rue de la Fédération**
**F-75015 Paris (FR)**

(72) Inventeur : **Chaillout, Jean-Jacques**
**Le Montagnier Haut**
**F-38960 St Etienne de Crossey (FR)**
Inventeur : **Kernevez, Nelly**
**14 Bld Maréchal Leclerc**
**F-38000 Grenoble (FR)**
Inventeur : **Leger, Jean-Michel**
**51C, rue des Ayguinards**
**F-38240 Meylan (FR)**

(74) Mandataire : **Mongrédien, André et al**
**c/o BREVATOME 25, rue de Ponthieu**
**F-75008 Paris (FR)**

EP 0 462 000 B1

## Description

La présente invention a pour objet un magnétomètre. Elle trouve une application dans la mesure précise des champs magnétiques faibles (typiquement dans la plage de 20 à 70 $\mu$T correspondant aux valeurs du champ magnétique terrestre).

Le magnétomètre de l'invention entre dans la catégorie des magnétomètres dits à résonance, dont on pourra trouver une description générale dans l'article de F. HARTMAN intitulé "Resonance Magnetometers", publié dans la revue "IEEE Transactions on Magnetics", vol. MAG-8, n° 1, March 1972, pp. 66-75.

Un magnétomètre à résonance est un appareil qui, plongé dans un champ magnétique Bo, délivre un signal électrique de fréquence F dont la valeur est liée à Bo par la relation dite de LARMOR :

$$F = \gamma Bo$$

où $\gamma$ est un rapport gyromagnétique (d'un électron ou d'un nucléon selon la substance utilisée). Pour l'électron par exemple, ce rapport est égal à 28Hz/nT.

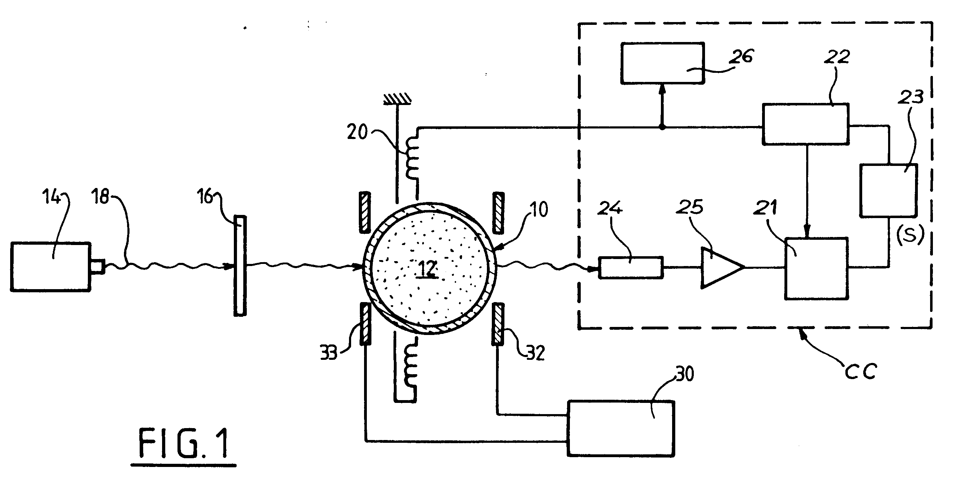

Dans cette classe d'appareils, le magnétomètre à pompage optique occupe une place privilégiée. La constitution générale d'un magnétomètre à pompage optique et à résonance magnétique est représentée schématiquement sur la figure 1.

Une cellule 10, au moins partiellement transparente, est remplie d'un gaz 12, en général de l'hélium à une pression de 1 à quelques torrs. Une source lumineuse 14 délivre un faisceau lumineux 18 dont la longueur d'onde se situe autour de 1,1$\mu$m dans le cas de l'hélium. Ce faisceau est convenablement polarisé par un moyen 16 puis injecté dans la cellule 10.

Par ailleurs, une décharge radio-fréquence (dite "faible" ou "douce") est produite dans le gaz par un générateur 30 relié à deux électrodes 32, 33 disposées autour de la cellule 10. Cette décharge produit des atomes dans un état métastable ($2^3S_1$ dans le cas de l'hélium). Le faisceau lumineux incident 18 "pompe" ces atomes à partir de l'état métastable pour les amener dans un autre état excité ($2^3P$).

En présence d'un champ magnétique Bo, les niveaux d'énergie se séparent en sous-niveaux, dits de ZEEMAN. Une résonance entre de tels sous-niveaux peut être établie par un champ radio-fréquence (résonance magnétique) ou par une modulation de la lumière (double résonance optique ; COHEN, TANNOUDJI, Ann. Phys., 7, 1962, p. 423). Dans le cas de l'hélium, isotope 4, la résonance s'établit entre deux sous-niveaux électroniques ZEEMAN de l'état métastable. Cette résonance est mise en évidence par divers moyens électroniques connus de l'homme du métier, dont une variante est représentée sur la figure 1. Il s'agit d'un enroulement 20 disposé de part et d'autre de la cellule 10 (dans une disposition dite de HELMOLTZ), d'un générateur radio-fréquence 22, et d'un photodétecteur 24 recevant le rayonnement lumineux ayant traversé la cellule, d'un amplificateur 25, d'une détection synchrone 21 et d'un intégrateur 23. L'ensemble des moyens 21 à 26 sera désigné globalement dans la suite par la référence CC. Le générateur 22 alimente l'enroulement 20 en courant à la fréquence F, ce qui crée un champ magnétique oscillant dont une composante entretient la résonance et module en retour le faisceau lumineux ayant traversé la cellule. Cette modulation constitue le signal. Elle est mise en évidence par la détection synchrone en sortie du photodétecteur via l'amplificateur. La référence est donnée par le générateur. La sortie de la détection synchrone correspondant à la composante du signal en phase avec la référence sert de signal d'erreur. L'intégrateur en élimine l'erreur statique. Ce signal d'erreur réajuste la fréquence F du synthétiseur à la fréquence de LARMOR. Il faut pour cela que le synthétiseur soit pilotable en tension ; il peut également être remplacé par un oscillateur commandé en tension (V.C.O.).

Un signal électrique de résonance s'établit ainsi dans cette boucle, à la fréquence de LARMOR. Un fréquencemètre 26 en donne la valeur F. Le champ à mesurer Bo d'en déduit par la relation Bo=F/$\gamma$.

Les magnétomètres à hélium de ce type ont d'abord utilisé des lampes à hélium. L'obtention récente de cristaux d'aluminate de lanthane-néodyme (ou LNA) ayant permis de réaliser des lasers accordables autour de la longueur d'onde de 1,083 $\mu$m correspondant précisément à la raie de pompage optique de l'hélium, ce type de laser s'est substitué tout naturellement à ces lampes avec une amélioration sensible des performances, ce qui a donné un regain d'intérêt à ces appareils.

Un tel magnétomètre, équipé d'un laser à LNA, est décrit dans le document FR-A-2 598 518.

Bien que satisfaisants à certains égards, ces magnétomètres présentent cependant des inconvénients. En effet, par principe, ils sont fortement anisotropes, et ceci à la fois en amplitude et en fréquence. Des extinctions de signal se produisent pour certaines orientations du champ magnétique à mesurer. Ces orientations défavorables correspondantes soit à certaines directions de propagation du faisceau lumineux (dans le cas d'une polarisation circulaire) soit à certaines directions de polarisation (dans le cas d'une polarisation rectiligne). Le pompage optique ne produit plus alors la polarisation requise des sous-niveaux ZEEMAN des atomes, ou la détection de la résonance se révèle inefficace.

Diverses solutions ont été proposées pour remédier à cet inconvénient. La Société américaine Texas Instruments, par exemple, préconise l'utilisation de plusieurs cellules orientées de telle sorte que l'une au moins fournisse un signal exploitable. La Société canadienne Canadian Aviation Electronics préconise plutôt d'orienter convenablement le magnétomètre par rapport au champ à mesurer.

Les zones d'extinction du signal étant plus étendues pour un faisceau polarisé rectilignement que pour un faisceau polarisé circulairement, on préfère en général travailler en polarisation circulaire. Cependant, avec ce type de polarisation, un phénomène de déplacement de fréquence se produit, du fait du pompage optique, qui provoque des erreurs de mesure.

La Société Texas Instruments remédie à cet autre inconvénient toujours en doublant le nombre de cellules, et en faisant fonctionner l'une d'entre elles en polarisation circulaire droite et l'autre en polarisation circulaire gauche. Les décalages de fréquence observés dans les deux cellules sont alors de signes opposés, et une compensation est possible en effectuant la moyenne des deux fréquences mesurées.

Toutes ces solutions, qui reviennent à multiplier le nombre d'appareils, restent peu satisfaisantes : encombrement excessif, nécessité d'équilibrer les diverses voies de mesure, commande de l'orientation des cellules, consommation électrique élevée, etc.... Par ailleurs, toute l'installation doit être réalisée dans un environnement amagnétique, ce qui pose de redoutables problèmes technologiques.

La présente invention a justement pour but de remédier à ces inconvénients. A cette fin, elle propose un magnétomètre à résonance et à pompage optique dont l'isotropie est excellente tout en restant simple de construction et peu encombrant (il ne comprend qu'une seule cellule).

Ce but est atteint par l'invention grâce à l'utilisation d'une pluralité de faisceaux lumineux injectés successivement dans la cellule dans des directions différentes. En d'autres termes, on effectue un multiplexage des faisceaux lumineux. La pluralité de faisceaux employée entraîne l'obtention d'une pluralité de signaux de résonance, plus ou moins affaiblis et/ou affectés d'erreur (selon l'orientation du champ à mesurer par rapport à la polarisation employée). Mais, il est toujours possible d'extraire de ces signaux un signal global débarrassé de ces défauts. Dès lors, quelle que soit l'orientation du champ magnétique à mesurer, le magnétomètre délivre un signal significatif.

De façon précise, la présente invention a pour objet un magnétomètre à résonance et à pompage optique qui comprend, en plus des moyens connus déjà évoqués, un multiplexeur optique recevant le faisceau lumineux émis par la source et délivrant successivement $n$ faisceaux lumineux, $n$ étant un entier au moins égal à 2, ces $n$ faisceaux traversant $n$ moyens de polarisation et étant injectés ensuite dans la cellule selon $n$ directions ou polarisations différentes pour y pomper optiquement le gaz, les moyens de détection du signal électrique de résonance délivrant successivement $n$ composantes correspondant aux $n$ faisceaux de pompage optique.

Deux variantes sont prévues :
- la première consiste à prendre la moyenne des amplitudes de la pluralité des $n$ signaux obtenus ; cette moyenne est nécessairement supérieure à la plus petite des amplitudes obtenues : le signal de mesure est donc toujours supérieur au signal qui serait délivré par un magnétomètre placé dans les conditions les plus défavorables ;
- la seconde consiste à comparer l'amplitude du signal de résonance obtenu avec l'un ses faisceaux avec une valeur de consigne ; si cette amplitude est inférieure à la valeur de consigne, on continue à passer d'un faisceau à l'autre ; dès que l'une des amplitudes excède la valeur de consigne, on arrête le multiplexage et l'on garde le faisceau correspondant.

Dans une troisième variante, le multiplexeur est commandé par des moyens sensibles à l'orientation du champ ambiant et capables se déterminer lequel des $n$ faisceaux est le mieux adapté à la mesure du champ ambiant, compte tenu de l'orientation de celui-ci.

Ces moyens, sensibles à l'orientation du champ, peuvent être constitués par un magnétomètre directionnel ou par un ensemble d'enroulement d'axes différents.

Dans toutes ces variantes, les divers faisceaux lumineux sont de préférence guidés par des fibres optiques depuis la source jusqu'à la cellule en passant par le multiplexeur et les polariseurs et depuis la cellule jusqu'au photodétecteur.

Chaque dispositif de polarisation associé à un faisceau peut introduire une polarisation rectiligne ou une polarisation circulaire. Une combinaison d'un polariseur rectiligne et d'une lame quart d'onde créent une polarisation circulaire. Un seul polariseur rectiligne fournit une polarisation rectiligne.

Toutes ces dispositions s'appliquent aux magnétomètres à résonance et à pompage optique, quel que soit le milieu pompé. Cependant, dans l'état actuel de la technique, on préfère utiliser l'hélium. Mais d'autres gaz ou fluides connus ou à venir ne sont pas exclus pour autant de l'invention, comme par exemple les vapeurs de métaux alcalins (césium, rubidium, etc...).

De même, si le laser à LNA joue un rôle privilégié dans le pompage des cellules à hélium, l'invention ne se limite pas à cette source et tout magnétomètre utilisant une source lumineuse quelconque fait partie de l'invention, dès lors qu'il travaille avec ses faisceaux multiplexés. La résonance peut être magnétique (excitation par un champ RF) ou optique (modulation de la lumière, multirésonance optique).

De toute façon, les caractéristiques et avantages de l'invention apparaîtront mieux à la lumière de la description qui va suivre. Cette description porte sur des exemples de réalisation donnés à titre explicatif et nullement limitatif et elle se réfère à des dessins annexés, sur lesquels :
- la figure 1, déjà décrite, montre un magnétomètre de l'art antérieur ;

- la figure 2A, 2B représente schématiquement un magnétomètre selon l'invention ;
- la figure 3 est un schéma explicatif du fonctionnement du magnétomètre de l'invention ;
- la figure 4 illustre une variante à amplitude de consigne ;
- la figure 5 illustre une variante à magnétomètre directionnel ;
- la figure 6 illustre une variante à enroulements multiplexés ;
- la figure 7 montre une variante à changement de polarisation sur un même faisceau ;
- la figure 8 montre quelques exemples d'orientation possible pour les directions des faisceaux lumineux.

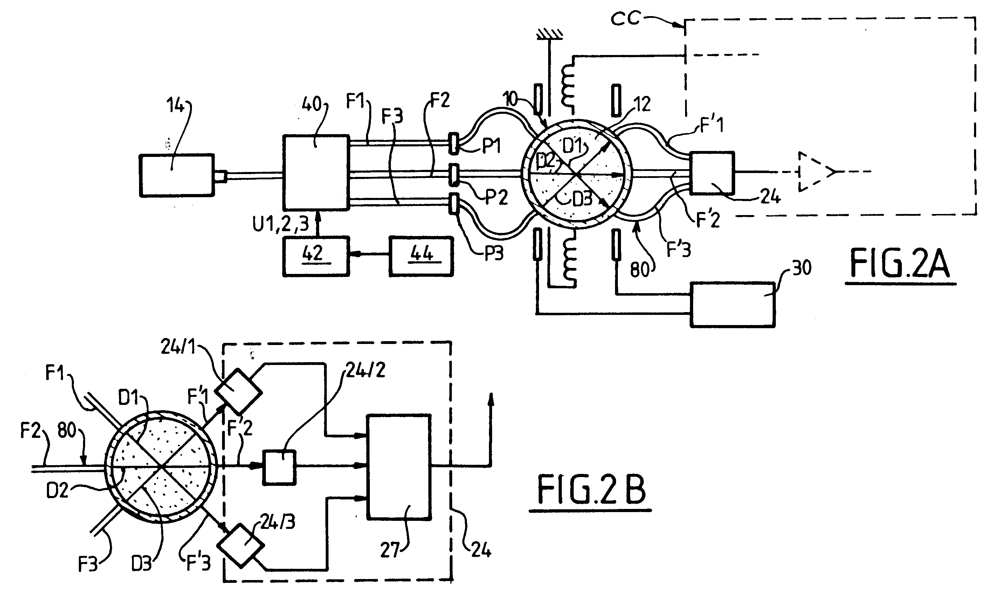

Le magnétomètre représenté sur la figure 2A comprend tout d'abord des moyens connus déjà illustrés sur la figure 1 et qui portent, pour cette raison, les mêmes références numériques. Il s'agit de la cellule 10 remplie d'hélium, du laser 14, de l'enroulement 20, du circuit CC (comprenant le générateur radio-fréquence 22, le photodétecteur 24, le fréquencemètre 26, l'amplificateur 25, la détection synchrone 21 et l'intégrateur 23) et du générateur de décharge 30. Selon l'invention, le magnétomètre comprend en outre un multiplexeur optique 40 par exemple à 3 sorties (du type SN 1:3 de la Société JDS Optics) commandé par un générateur de tension 42. Ce multiplexeur émet trois signaux lumineux F1, F2, F3, de préférence guidés par trois fibres optiques. Ces faisceaux traversent trois polariseurs P1, P2, P3 (rectilignes ou circulaires) et sont injectés dans la cellule 10 sous trois directions différentes D1, D2, D3.

La photodétection des faisceaux ayant traversé la cellule peut s'effectuer de deux manières différentes : dans la variante illustrée sur la figure 2A, trois fibres optiques guident les faisceaux émergents F'1, F'2, F'3 vers un seul photorécepteur 24 ; dans la variante de la figure 2B, trois photodétecteurs 24/1, 24/2, 24/3 détectent séparément les trois faisceaux F'1, F'2, F'3 et un additionneur 27 fait la somme des signaux électriques.

En d'autres termes, la sommation des signaux peut être optique ou électrique.

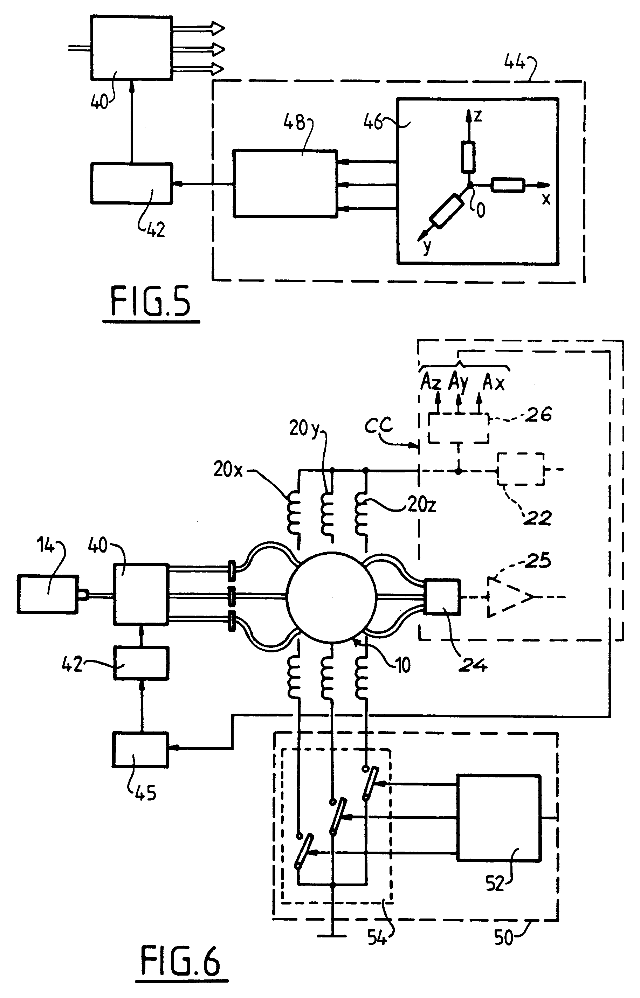

Le magnétomètre de la figure 2A peut comprendre en outre des moyens 44 aptes à commander le générateur 42, comme il est décrit plus loin en liaison avec les figures 4 à 6.

Il peut comprendre également un circuit apte à faire la moyenne des amplitudes de signaux électriques.

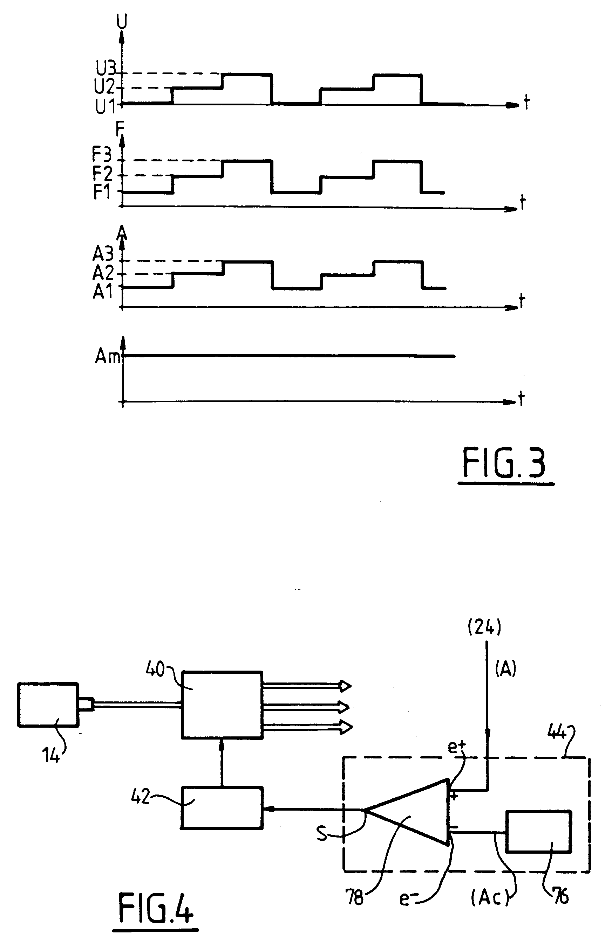

Le schéma de la figure 3 explique le fonctionnement de ce dispositif. Le générateur 42 délivre trois tensions U1, U2, U3 qui commandent le multiplexeur optique 40 (première ligne). Selon la tension appliquée, un faisceau parmi trois (FP1, FP2 ou FP3) est émis en sortie du multiplexeur (deuxième ligne). Pour chacun de ces faisceaux, le signal électrique de résonance établi dans le circuit 20, 22, 24 possède une certaine amplitude, respectivement A1, A2, A3 (troisième ligne). Ces amplitudes sont plus ou moins grandes, selon que la direction ou la polarisation du faisceau D1, D2, D3 par rapport au champ Bo à mesurer est favorable ou non. Un circuit apte à effectuer la moyenne des signaux, délivre un signal d'amplitude moyenne Am (dernière ligne), qui est le signal dont on mesure la fréquence F.

Selon un mode de réalisation illustré sur la figure 4, le magnétomètre comprend un moyen 76 apte à délivrer une valeur de consigne Ac, un comparateur 78 qui reçoit, sur une première entrée $e^+$, l'amplitude A du signal détecté, et, sur une seconde entrée $e^-$, la valeur de consigne Ac. Ce comparateur 78 possède une sortie s reliée au générateur 42.

L'état logique de la sortie s (par exemple "1"), obtenu lorsque l'amplitude mesurée A est inférieure à la valeur de consigne Ac, a pour effet de commander l'application sur le générateur 42 d'une tension apte à maintenir le multiplexage. L'apparition de l'autre état logique sur cette sortie ("0"), lorsque l'amplitude mesurée A excède la valeur de consigne Ac, a pour effet d'arrêter le multiplexage et de conserver le faisceau correspondant soit maintenu.

Dans ces variantes illustrées par les figures 2A, 2B, 4, le multiplexage s'effectue de façon autonome, sans recours à des moyens auxiliaires. Dans une autre série de variantes, le multiplexage est piloté à partir de moyens annexes, schématisés par le bloc 44 de la figure 2A. Plusieurs modes de réalisation sont prévus.

Le premier est illustré sur la figure 5. Il correspond à l'utilisation d'un magnétomètre directionnel 46, par exemple à trois "flux-gates" ou à RPE (Résonance Paramagnétique Electronique), donnant des informations sur la direction du champ ambiant Bo par rapport à trois axes Ox, Oy, Oz. Un circuit 48 traite ces informations et calcule l'orientation optimale de la direction du faisceau (compte tenu de sa polarisation) correspondant à cette direction du champ ambiant. Il commande en conséquence le générateur 42 pour que le multiplexeur 40 sélectionne le faisceau dont la direction est la plus approchée.

Selon un autre mode de réalisation illustré, sur la figure 6, on utilise une disposition décrite -mais utilisée dans un autre but- dans la demande de brevet français déposée simultanément par le présent Demandeur pour "Magnétomètre à résonance magnétique et à enroulements d'excitation multiplexés". Cette disposition consiste à munir la cellule 10 de trois enroulements de détection 20x, 20y, 20z disposés autour de la cellule 10 avec des axes d'orientations différentes entre eux (par exemple en trièdre trirectangle). Ces enroulements sont mis en circuit séquentiellement par un multiplexeur électrique 50 comprenant un générateur d'impulsions de multiplexage 52 et des interrupteurs 54.

L'utilisation de plusieurs enroulements multiplexés permet d'obtenir plusieurs signaux de résonance dont les fréquences respectives Ax, Ay, Az dépendent des orientations relatives du champ ambiant par rapport aux axes des enroulements. La connaissance de ces fréquences permet de déterminer l'orientation du champ.

L'orientation du champ étant connue, la direction optimale du faisceau lumineux s'en déduit. C'est le rôle du circuit de calcul 45 de déterminer cette direction et de délivrer au générateur 42 le signal de commande approprié au multiplexeur optique 40.

A cet égard, on pourra consulter l'article de COHEN-TANNOUDJI publié dans les Annales de Physique 7, 1962, pp. 423-429 qui donne l'amplitude du signal en fonction des angles relatifs entre le faisceau et le champ.

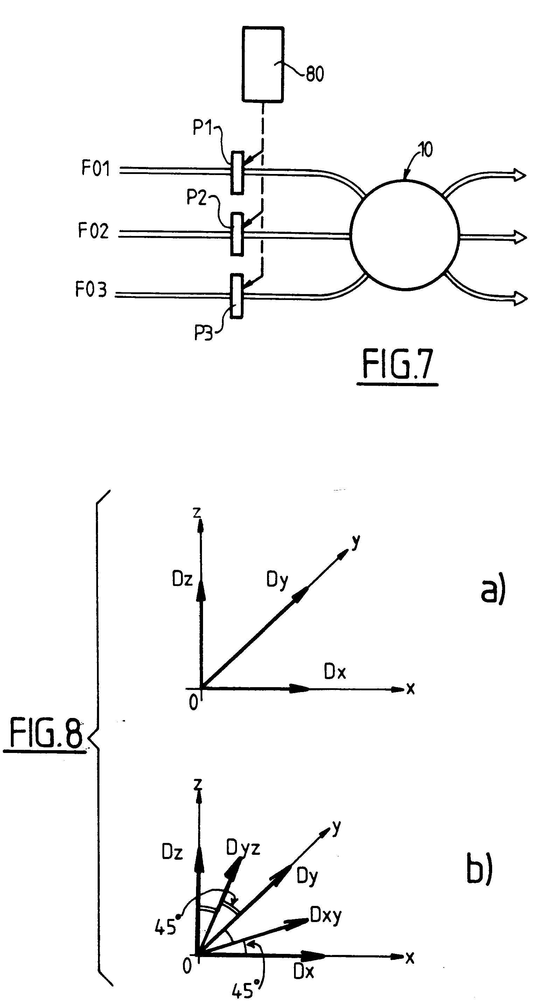

Comme indiqué plus haut, les polarisations des faisceaux peuvent être quelconques. Elles peuvent même être modifiées en cours de fonctionnement. Sur la figure 7, on voit ainsi un moyen 80 capable d'agir sur les polariseurs P1, P2, P3 insérés dans les guides optiques F01, F02, F03.

Un polariseur circulaire pouvant être constitué d'un polariseur rectiligne et d'une lame quart d'onde, le moyen 80 est par exemple capable de faire tourner la lame quart d'onde de 90°, pour passer d'une polarisation circulaire droite à une polarisation circulaire gauche, ou de 45° pour obtenir une polarisation rectiligne. Le moyen 80 peut aussi escamoter la lame quart d'onde ou le polariseur rectiligne.

Si le laser 14 émet un rayonnement intrinsèquement polarisé rectilignement, les polariseurs P1, P2, P3 peuvent être supprimés, sauf si l'on veut faire tourner le plan se polarisation ou passer en polarisation circulaire.

Le choix du nombre $n$ de faisceaux dépend de l'isotropie recherchée, du mode de détection, du type de polarisation et de la complexité tolérée pour le dispositif. Un nombre n égal à 3 semble un minimum.

A titre d'exemple :

a) sans le cas d'une détection transverse à polarisation circulaire, le nombre n sera égal à trois avec des directions de faisceaux disposées en trièdre trirectangle. C'est ce qui est représenté symboliquement sur la figure 8, partie a, où ces directions sont notées Dx, Dy, Dz. Cette disposition permet d'obtenir une isotropie d'amplitude de 57% (l'isotropie étant définie comme le rapport de l'amplitude minimum à l'amplitude maximum), b) sans le cas d'une détection longitudinale à polarisation rectiligne, un nombre n égal à 5 semble convenable, conformément à la figure 8, partie b. Trois des directions de polarisation sont en trièdre trirectangle (Dx, Dy, Dz) et les deux autres (Dxy, Dxz) sont sans ses plans définis par deux des trois directions Dx, Dy, Dz et à 45° desdites directions.

On observera que l'angle dont il est question dépend du type de polarisation employé :

- lorsque la polarisation est circulaire, l'angle en question est l'angle que le champ à mesurer fait avec la direction de propagation du faisceau lumineux ;
- lorsque la polarisation est rectiligne, il s'agit de l'angle que le champ à mesure fait avec la direction de polarisation.

**Revendications**

1. Magnétomètre à résonance et à pompage optique comportant une cellule (10) remplie d'un gaz (12) présentant un rapport gyromagnétique $\gamma$, une source lumineuse (14) émettant un faisceau lumineux, des moyens (20 à 25) de détection d'un signal électrique de résonance (S) à une fréquence de LARMOR $F=\gamma Bo$ où Bo est un champ magnétique ambiant dans lequel plonge la cellule (10) et qui est le champ à mesurer, un moyen (26) pour mesurer cette fréquence, l'amplitude du champ magnétique ambiant se déduisant de la fréquence F par la relation $Bo=F/\gamma$,

   ce magnétomètre étant caractérisé par le fait qu'il comprend un multiplexeur optique (40, 42) recevant le faisceau lumineux émis par la source (14) et délivrant successivement $n$ faisceaux lumineux (F1, F2, ...), $n$ étant un entier au moins égal à 2, ces $n$ faisceaux (F1, F2, ...) traversant $n$ moyens de polarisation (P1, P2, ...) et étant injectés ensuite dans la cellule (10) selon $n$ directions ou polarisations différentes (D1, D2, ...) pour y pomper optiquement le gaz, les moyens de détection du signal électrique de résonance délivrant successivement $n$ signaux correspondant aux $n$ faisceaux de pompage optique.

2. Magnétomètre selon la revendication 1, caractérisé par le fait qu'il comprend, en outre, un moyen (76) apte à délivrer une valeur de consigne (Ac), un comparateur (78) recevant, sur une première entrée ($e^+$), l'amplitude (A) du signal détecté, et, sur une seconde entrée ($e^-$), la valeur de consigne (Ac), ce comparateur (78) ayant une sortie (s) reliée à un générateur de commande (42) du multiplexeur (40), le premier état logique de cette sortie (s), obtenu lorsque l'amplitude mesurée (A) est inférieure à la valeur de consigne (Ac), commandant le générateur (42) pour le multiplexage des faisceaux optiques et un second état logique de cette sortie (s), obtenu lorsque l'amplitude mesurée (A) excède la valeur de consigne (Ac), commandant l'arrêt du générateur (42) et du multiplexage.

3. Magnétomètre selon la revendication 1, caractérisé par le fait que le multiplexeur (40, 42) est commandé par des moyens (44) sensibles à l'orientation du champ ambiant et capables de déterminer lequel des n faisceaux est le mieux adapté à la mesure du champ ambiant compte tenu de l'orientation de celui-ci, ces moyens commandant le multiplexeur (40, 42) pour qu'il n'émette que le faisceau le mieux adapté.

4. Magnétomètre selon la revendication 3, caractérisé par le fait que les moyens (44) sensibles à l'orientation du champ sont constitués par un magnétomètre directionnel.

5. Magnétomètre selon la revendication 3, caractérisé par le fait que les moyens (44) sensibles à l'orientation du champ sont constitués par :
   - un ensemble de trois enroulements d'excitation (20x, 20y, 20z) disposés autour de la cellule (10) et d'axes différents,
   - un multiplexeur électrique (50) mettant en circuit séquentiellement ces enroulements (20x, 20y, 20z),
   - un circuit (44) de traitement du signal de détection obtenu avec ces trois enroulements, ce circuit (44) déterminant celui des n faisceaux qui est le mieux adapté à la mesure du champ.

6. Magnétomètre selon la revendication 1, caractérisé par le fait qu'il comprend un seul photodétecteur (24) recevant les n signaux lumineux ayant traversé la cellule (10).

7. Magnétomètre selon la revendication 1, caractérisé par le fait qu'il comprend n photorécepteurs (24/1, 24/2, ...) sensibles respectivement aux n faisceaux lumineux (F'1, F'2, ...) ayant traversé la cellule (10) et un additionneur (27) des n signaux délivrés par les n photorécepteurs.

8. Magnétomètre selon la revendication 1, caractérisé par le fait que les n faisceaux lumineux délivrés par le multiplexeur (40) sont guidés respectivement par n fibres optiques (F01, F02, F03).

9. Magnétomètre selon la revendication 6, caractérisé par le fait que les n faisceaux lumineux ayant traversé la cellule (10) sont guidés respectivement vers le photodétecteur (24) par n fibres optiques.

10. Magnétomètre selon la revendication 1, caractérisé par le fait que chaque polariseur (P1, P2, P3) associé à chaque faisceau est un polariseur rectiligne.

11. Magnétomètre selon la revendication 1, caractérisé par le fait que chaque polariseur (P1, P2, P3) associé à chaque faisceau est un polariseur circulaire.

12. Magnétomètre selon la revendication 1, caractérisé par le fait que certains polariseurs sont des polariseurs rectilignes et d'autres des polariseurs circulaires.

13. Magnétomètre selon la revendication 1, caractérisé par le fait que le nombre n de faisceaux est égal à 3.

14. Magnétomètre selon la revendication 13, caractérisé par le fait que les trois faisceaux ont des polarisations circulaires et des directions orthogonales deux à deux (Dx, Dy, Dz).

15. Magnétomètre selon la revendication 1, caractérisé par le fait que le nombre n de faisceaux injectés est égal à 5.

16. Magnétomètre selon la revendication 15, caractérisé par le fait que les cinq faisceaux ont des polarisations rectilignes, les directions de trois d'entre elles formant un trièdre trirectangle (Dx, Dy, Dz) et les directions des deux autres (Dxy, Dxz) étant dans deux plans définis par deux desdites trois directions et à 45° desdites directions (Dxy) (Dxz).

17. Magnétomètre selon la revendication 1, caractérisé par le tait qu'il comprend des moyens (80) pour modifier la polarisation (en direction et/ou en nature) sur chaque faisceau lumineux injecté dans la cellule.

18. Magnétomètre selon l'une quelconque des revendications 1 à 17, caractérisé par le fait que le gaz (12) de la cellule (10) est de l'hélium.

19. Magnétomètre selon la revendication 18, caractérisé par le fait qu'il comprend en outre des moyens (30, 32, 33) pour créer une décharge haute fréquence dans la cellule d'hélium (10).

20. Magnétomètre selon l'une quelconque des revendications 1 à 19, caractérisé par le fait que la source lumineuse (14) est un laser.

**Patentansprüche**

1. Optisch gepumptes Resonanz-Magnetometer, umfassend eine Zelle (10), gefüllt mit einem Gas (12), ein gyromagnetisches Verhältnis $\gamma$ aufweisend, eine Lichtquelle (14), ein Strahlenbündel aussendend, Festellungseinrichtungen (20, 25) eines elektrischen Resonanzsignals (S) mit einer Larmor-Frequenz F=$\gamma$ Bo, wobei Bo ein umgebendes Magnetfeld ist, in das die Zelle (10) getaucht ist und welches das zu messende Feld ist, eine Einrichtung (26) um dieses Feld zu messen, wobei die Stärke des umgebenden Magnetfelds sich ableitet aus der Frequenz F durch das Verhältnis Bo=F/$\gamma$, wobei dieses Magnetometer dadurch **gekennzeichnet** ist,

daß es einen optischen Multiplexer (40, 42) enthält, der das von der Quelle (14) ausgesandte Strahlenbündel empfängt und nacheinander n Strahlenbündel (F1, F2, ...) liefert, wobei n eine Ganzzahl wenigstens gleich 2 ist, wobei diese n Strahlen (F1, F2, ...) n polisarisationseinrichtungen (P1, P2, ...) durchqueren und anschließend in die Zelle (10) injiziert werden entsprechend n Richtungen oder unterschiedlichen Polarisationen (D1, D2, ...), um dort das Gas optisch zu pumpen, wobei die Festellungseinrichtungen nacheinander n Signale liefern, entsprechend den n optisch gepumpten Strahlen.

2. Magnetometer nach Anspruch 1, dadurch gekennzeichnet, daß es außerdem eine Einrichtung (76) umfaßt, fähig einen Einstellgrößenwert (Ac) zu liefern, einen Komparator (78), an einem ersten Eingang (e$^+$) die Amplitude (A) des festgestellten Signals empfangend und an einem zweiten Eingang (e$^-$) den Eistellgrößenwert (Ac), wobei dieser Komparator (78) einen Ausgang (s) hat, verbunden mit einem Steuerungs-bzw. Befehlsgenerator (42) des Multiplexers (40), wobei der erste logische Zustand dieses Ausgangs (s), erreicht wenn die gemessene Amplitude (A) kleiner ist als der Einstellgrößenwert (Ac), den Gererator (42) für das Multiplexen der Lichtstrahlen steuert, und ein zweiter logischer Zustand dieses Ausgangs (s), erreicht wenn die gemessene Amplitude (A) größer ist als der Einstellgrößenwert (Ac), das Anhalten des Generators (42) und des Multiplexens steuert.

3. Magnetometer nach Anspruch 1, dadurch gekennzeichnet, daß der Multiplexer gesteuert wird durch Einrichtungen (44), die empfindlich sind für die Ausrichtung des Umgebungsfelds und fähig, zu bestimmen, welcher der n Strahlen am besten geeignet ist für die Messung des Umgebungsfelds unter Berücksichtigung von dessen Ausrichtung, wobei diese Einrichtungen den Multiplexer (40, 42) so steuern, daß er nur den am besten geeigneten Strahl aussendet.

4. Magnetometer nach Anspruch 3, dadurch gekennzeichnet, daß die für die Ausrichtung des Felds empfindlichen Einrichtungen (44) gebildet werden durch ein Richtmagnetometer.

5. Magnetometer nach Anspruch 3, dadurch gekennzeichnet, daß die für die Ausrichtung des Felds empfindlichen Mittel (44) gebildet werden durch:

  - einen Aufbau von drei Erregerwicklungen (20x, 20y, 20z), angeordnet um die Zelle (10) herum und mit differierenden Achsen,
  - einen elektrischen Multiplexer (50), der diese Wicklungen (20x, 20y, 20z) sequentiell zuschaltet,
  - einen Verarbeitungsschaltkreis (44) des mit diesen drei Wicklungen erzielten Feststellungssignals, wobei dieser Schaltkreis (44) aus den n Strahlen denjenigen bestimmt, der für die Feldmessung am besten geeignet ist.

6. Magnetometer nach Anspruch 1, dadurch gekennzeichnet, daß er einen einzigen Photodetektor (24) enthält, der die n Lichtsignale empfängt, welche die Zelle (10) durchquert haben.

7. Magnetometer nach Anspruch 1, dadurch gekennzeichnet, daß er n Photorezeptoren (24/1, 24/2, ...) enthält, die jeweils empfindlich sind für n Lichtstrahlen (F'1, F'2, ...), welche die Zelle (10) durchquert haben, und einen Addierer (27), der von den n photorezeptoren gelieferten n Signale.

8. Magnetometer nach Anspruch 1, dadurch gekennzeichnet, daß die von dem Multiplexer (40) gelieferten n Lichtstrahlen geleitet werden durch n Lichtleitfasern (FO1, FO2, FO3).

9. Magnetometer nach Anspruch 6, dadurch gekennzeichnet, daß die n Lichtstrahlen, welche die Zelle (10) durchquert haben, jeweils durch n Lichtleitfasern zum Photodetektor (24) geleitet werden.

10. Magnetometer nach Anspruch 1, dadurch gekennzeichnet, daß jeder Polarisator (P1, P2, P3), jedem Lichtstrahl zugeordnet, ein linearer Polaristor ist.

11. Magnetometer nach Anspruch 1, dadurch gekennzeichnet, daß jeder Polaristor (P1, P2, P3), jedem Lichtstrahl zugeordnet, ein zirkularer Polarisator ist.

12. Magnetometer nach Anspruch 1, dadurch gekennzeichnet, daß bestimmte Polisatoren lineare Polisatoren sind, und andere zirkulare Polisatoren sind.

13. Magnetometer nach Anspruch 1, dadurch gekennzeichnet, daß die Strahlenanzahl n gleich 3 ist.

14. Magnetometer nach Anspruch 13, dadurch gekennzeichnet, daß die drei Strahlen zirkulare Polarisationen haben und paarweise rechtwinklige Richtungen (Dx, Dy, Dz).

15. Magnetometer nach Anspruch 1, dadurch gekennzeichnet, daß die Strahlenanzahl n der injizierten Strahlen gleich 5 ist.

16. Magnetometer nach Anspruch 15, dadurch gekennzeichnet, daß die fünf Strahlen lineare Polarisationen haben, wobei die Richtungen von drei von ihnen einen Trieder mit drei rechten Winkeln bilden (Dx, Dy, Dz), und die Richtungen der beiden anderen (Dxy, Dxz) in zwei Ebenen liegen, die definiert werden durch die genannten drei Richtungen, unter 45° zu diesen genannten Richtungen.

17. Magnetometer nach Anspruch 1, dadurch gekennzeichnet, daß es Einrichtungen (80) enthält, um bei jedem in die Zelle injizierten Strahl die Polarisierung zu modifizieren (bezüglich der Richtung und/oder bezüglich der Art).

18. Magnetometer nach einem der Ansprüche 1 bis 17, dadurch gekennzeichnet, daß das Gas (12) der Zelle (10) Helium ist.

19. Magnetometer nach Anspruch 18, dadurch gekennzeichnet, daß es außerdem Einrichtungen (30, 32, 33) enthält, um eine Hochfrequenz-Entladung in der Heliumzelle (10) zu erzeugen.

20. Magnetometer nach einem der Ansprüche 1 bis 19, dadurch gekennzeichnet, daß die Lichtquelle (14) ein Laser ist.

**Claims**

1. Optical pumping, resonance magnetometer having a cell (10) filled with a gas (12) having a gyromagnetic ratio $\gamma$, a light source (14) emitting a light beam, means (20 to 25) for detecting an electric resonance signal (S) at a LARMOR frequency $F = \gamma Bo$, in which Bo is an ambient magnetic field in which is immersed the cell (10) and which is the field to be measured, a means (26) for measuring the said frequency, the amplitude of the ambient magnetic field being deduced from the frequency F by the relation $Bo = F/\gamma$, said magnetometer being characterized in that it comprises an optical multiplexer (40, 42) receiving the light beam emitted by the source (14) and successively supplying n light beams (F1, F2, etc.), n being an integer at least equal to 2, said n beams (F1, F2, etc.) traversing n polarization means (P1, P2, etc.) and then being injected into the cell (10) in n different polarizations or directions (D1, D2, etc.) in order to optically pump there the gas, the detection means of the electrical resonance signal successively supplying n signals corresponding to the n optical pumping beams.

2. Magnetometer according to claim 1, characterized in that it also comprises a means (76) able to supply a nominal value (Ac), a comparator (78) receiving on a first input ($e^+$) the amplitude (A) of the detected signal and on a second input ($e^-$) the nominal value (Ac), said comparator (78) having an output (s) connected to a control generator (42) of the multiplexer (40), the first logic state of said output (s), obtained when the measured amplitude (A) is below the nominal value (Ac), controlling the generator (42) for the multiplexing of the optical beams and a second logic state of said output (s), obtained when the measured amplitude (A) exceeds the nominal value (Ac), controlling the stopping of the generator (42) and the multiplexing.

3. Magnetometer according to claim 1, characterized in that the multiplexer (40, 42) is controlled by means (44) sensitive to the orientation of the ambient field and able to determine which of the n beams is the most appropriate for the measurement of the ambient field, taking account of the orientation thereof, said means controlling the multiplexer (40, 42) so that it only emits the most appropriate beam.

4. Magnetometer according to claim 3, characterized in that the means (44) sensitive to the orientation of the field are constituted by a directional magnetometer.

5. Magnetometer according to claim 3, characterized in that the means (44) sensitive to the orientation of the field are constituted by:
a plurality of three exciting windings (20x, 20y, 20z) arranged around the cell (10) and having different axes,
an electrical multiplexer (50) sequentially switching on the windings (20x, 20y, 20z) and
a circuit (44) for processing the detection signal obtained with these three windings, said circuit (44) determining which of the n beams is most appropriate for the measurement of the field.

6. Magnetometer according to claim 1, characterized in that it comprises a single photodetector (24) receiving the n light signals having traversed the cell (10).

7.  Magnetometer according to claim 1, characterized in that it comprises n photoreceivers (24/1, 24/2, etc.) respectively sensitive to the n light beams (F'1, F'2, etc.) which have traversed the cell (10) and an adder (27) of n signals supplied by the n photoreceivers.

8.  Magnetometer according to claim 1, characterized in that the n light beams supplied by the multiplexer (4) are respectively guided by n optical fibres (F01, F02, F03).

9.  Magnetometer according to claim 6, characterized in that the n light beams having traversed the cell (10) are respectively guided to the photodetector (24) by n optical fibres.

10. Magnetometer according to claim 1, characterized in that each polarizer (P1, P2, P3) associated with each beam is a linear polarizer.

11. Magnetometer according to claim 1, characterized in that each polarizer (P1, P2, P3) associated with each beam is a circular polarizer.

12. Magnetometer according to claim 1, characterized in that certain polarizers are linear polarizers and others are circular polarizers.

13. Magnetometer according to claim 1, characterized in that the number n of beams is equal to three.

14. Magnetometer according to claim 13, characterized in that the three beams have circular polarizations and pairwise orthogonal directionals (Dx, Dy, Dz).

15. Magnetometer according to claim 1, characterized in that the number n of injected beams is equal to 5.

16. Magnetometer according to claim 15, characterized in that the five beams have linear polarizations, the directions of three of them forming a trirectangular trihedron (Dx, Dy, Dz) and the directions of the two others (Dxy, Dxz) being in two planes defined by two of the said three directions and at 45° of said directions (Dxy, Dxz).

17. Magnetometer according to claim 1, characterized in that it comprises means (80) for modifying the polarization (in direction and/or type) on each light beam injected into the cell.

18. Magnetometer according to one of the claims 1 to 17, characterized in that the gas (12) of the cell (10) is helium.

19. Magnetometer according to claim 18, characterized in that it also comprises means (30, 32, 33) for creating a high frequency discharge in the helium cell (10).

20. Magnetometer according to any one of the claims 1 to 19, characterized in that the light source (14) is a laser.

FIG.1

EP 0 462 000 B1

EP 0 462 000 B1

FIG.2A

FIG.2B

FIG.3

FIG.4

FIG.5

FIG.6

FIG.7

a)

b)

FIG.8

14